**Europäisches Patentamt**

**European Patent Office**

**Office européen des brevets**

(11) Numéro de publication: **0 116 802**
**A1**

(12) **DEMANDE DE BREVET EUROPEEN**

(21) Numéro de dépôt: **83402542.1**

(22) Date de dépôt: **27.12.83**

(51) Int. Cl.³: **H 05 K 7/20**
**H 01 R 23/72, H 01 L 23/32**
**H 01 L 23/46**

(30) Priorité: **30.12.82 FR 8222075**

(43) Date de publication de la demande:
**29.08.84 Bulletin 84/35**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Dumont, Bernard**
**THOMSON-CSF SCPI 173, bld Haussmann**
**F-75379 Paris Cedex 08(FR)**

(72) Inventeur: **Proponet, Christian**
**THOMSON-CSF SCPI 173, bld Haussmann**
**F-75379 Paris Cedex 08(FR)**

(72) Inventeur: **Bancelin, Bernard**
**THOMSON-CSF SCPI 173, bld Haussmann**
**F-75379 Paris Cedex 08(FR)**

(72) Inventeur: **Brucker, Roland**
**THOMSON-CSF SCPI 173, bld Haussmann**
**F-75379 Paris Cedex 08(FR)**

(72) Inventeur: **Bories, Jean-Louis**
**THOMSON-CSF SCPI 173, bld Haussmann**
**F-75379 Paris Cedex 08(FR)**

(72) Inventeur: **Klein, Christiane**
**THOMSON-CSF SCPI 173, bld Haussmann**
**F-75379 Paris Cedex 08(FR)**

(74) Mandataire: **Benoit, Monique et al,**
**THOMSON-CSF SCPI 173, Bld Haussmann**
**F-75379 Paris Cedex 08(FR)**

(54) **Structure d'assemblage de circuits électroniques complexes, et procédé d'amélioration de la fiabilité d'un assemblage.**

(57) L'invention concerne une structure d'assemblage pour les boîtiers de circuits comportant un grand nombre de connexions extérieures (40).

La structure comporte cinq niveaux. Un niveau support mécanique, constitué par l'élément de refroidissement (13) en forme de boîtier comportant au moins deux faces principales planes. Le second niveau électrique est constitué par un circuit d'interconnexion (15), qui peut être replié sur les deux faces principales du refroidisseur (13). Les circuits complexes (16), intégrés ou hybrides, au quatrième niveau sont en liaison électrique, sans soudure, avec les pistes conductrices du circuit d'interconnexion (15) par l'intermédiaire d'élastomères conducteurs (18), sous pression (troisième niveau). Le cinquième niveau, mécanique, est constitué par une plaque isolante (19) et des cadres métalliques (17) qui positionnent et maintiennent les élastomères conducteurs (18) et les boîtiers de circuits (16). L'ensemble constitue un coffret intégré, autoprotégé, refroidit intérieurement.

Application aux matériels d'électronique professionnelle soumis à vibrations.

**FIG.2**

# STRUCTURE D'ASSEMBLAGE DE CIRCUITS ELECTRONIQUES COMPLEXES, ET PROCEDE D'AMELIORATION DE LA FIABILITE D'UN ASSEMBLAGE

La présente invention concerne une structure d'assemblage de circuits électroniques complexes, structure comportant les circuits d'interconnexions et les moyens de refroidissements et constituant, par sa forme, l'équivalent d'un coffret. Cette structure améliore la fiabilité du système électronique et facilite les interventions de tests ou de réparations, les circuits électroniques n'étant pas soudés sur les cartes de circuits d'interconnexions. L'invention trouve des avantages plus particulièrement lorsque les circuits électroniques sont des circuits intégrés ou des circuits hybrides, à l'échelle de grande intégration, eux-mêmes encapsulés dans les boîtiers adéquats, selon qu'il s'agit de circuits intégrés ou de circuits hybrides, comportant de l'ordre de 40 connexions d'accès extérieur, ou plus. La structure d'assemblage selon l'invention ne se justifie pas pour des circuits électroniques ne comportant par exemple que quelques transistors et des composants passifs, chacun n'ayant qu'un petit nombre de connexions d'accès extérieur.

Les objectifs de l'invention sont, parmi d'autres avantages,

- une diminution du nombre des interconnexions,

- la séparation des fonctions d'interconnexions, de fixation des composants, et de conditionnement, afin d'améliorer la fiabilité et faciliter la maintenance,

- diminuer l'encombrement,

- améliorer le refroidissement.

Dans les systèmes complexes actuels, les composants actifs, c'est-à-dire essentiellement des circuits intégrés encapsulés dans des boîtiers de type DIL, périmétriques ou hybrides, sont soudés sur des supports du genre circuits imprimés, dits "cartes filles", qui sont elles-mêmes interconnectées sur des "cartes-mères". Il s'ensuit une chaîne de points de connexions, le plus souvent par soudures, qui diminue la fiabilité, surtout face à des contraintes d'exploitation telles que les vibrations et les différences de température.

De plus, les composants sont généralement soudés par leurs connexions de sortie, ce qui fait que les fonctions connexions et fixation mécanique sont confondues, ce qui rend délicates les opérations de tests sur un composant - qui ne peut être dissocié de la carte - ou son remplacement.

Par ailleurs, les circuits sont refroidis par convexion soit naturelle soit forcée, le fluide le plus courant étant l'air parce que les liquides sont exclus dans la plupart des cas, sauf adaptation spéciale de certains boîtiers de composants, et pour certains matériels fixes au sol ; or un refroidissement par convection naturelle n'est pas très efficace, et par convection forcée il entraîne une pollution des circuits qui sont rapidement recouverts de poussière.

Enfin, puisqu'il s'agit de systèmes complexes, ces systèmes constitués de cartes de circuits imprimés interconnectées entre elles, par l'intermédiaire d'autres cartes de circuits imprimés ou de connecteurs dits "de fond de panier", ont un encombrement qui, toutes choses étant égales par ailleurs, est relativement volumineux. Or, l'évolution actuelle des techniques électroniques s'oppose aux systèmes trop encombrants qui ne sont pas admissibles dans certains cas, tels que les systèmes embarqués qui doivent obligatoirement être denses, très fiables en vibrations et, étant très complexes, être facilement démontables pour tests et éventuellement changement d'un composant. Ces systèmes étant denses nécessitent un refroidissement efficace pour évacuer les calories dégagées au cours du fonctionnement.

La structure d'assemblage selon l'invention apporte ces avantages. Elle utilise comme support rigide un boîtier en matériau bon conducteur de la chaleur, tel que le cuivre par exemple, à l'intérieur duquel circule un fluide de refroidissement en convection forcée. Sur deux grandes faces opposées du boîtier sont positionnés deux circuits imprimés, et les composants à sorties périmétriques ou surfaciques sont interconnectés avec les pistes conductrices des circuits imprimés, sans soudure, par l'intermédiaire d'élastomère conducteur. La fixation mécanique et le positionnement des boîtiers de circuits intégrés contre les circuits imprimés est obtenue par l'intermédiaire de cadres métalliques vissés dans le boîtier support : ces cadres centrent les boîtiers de circuits intégrés par rapport aux pistes de circuits imprimés et, en écrasant l'élastomère conducteur, assurent un bon contact électrique, entre les connexions de sorties et les pistes conductrices, ce contact résistant bien aux vibrations. De plus des bossages pratiqués dans le boîtier support, passant à travers les circuits imprimés ajourés convenablement à cet effet, assurent un contact thermique direct entre le fluide de refroidissement et le fond des boîtiers d'encapsulation de circuits intégrés, d'où il découle un bon refroidissement. L'intérêt des circuits d'interconnexions montés sur supports souples est que les circuits électroniques supportés par les deux grandes faces du boîtier peuvent être interconnectés directement, par un unique circuit d'interconnexions replié autour du boîtier, sans avoir recours à des connecteurs.

La structure d'assemblage selon l'invention comporte donc cinq niveaux :

- un niveau support mécanique et refroidissement, constitué par le boîtier en métal bon conducteur,

- un niveau interconnexion constitué par les circuits imprimés,

- un niveau liaisons sans soudures entre les circuits imprimés et les circuits intégrés, constitué par les élastomères conducteurs,

- un niveau composants actifs, constitué par les boîtiers de circuits intégrés,

- un niveau fixation mécanique et protection de l'ensemble, constitué par les cadres, l'ensemble constituant l'équivalent d'un coffret intégré, compact, refroidi intérieurement et de bonne fiabilité aux vibrations.

La structure d'assemblage selon l'invention comporte, dans sa forme préférée la plus efficace une symétrie par rapport au plan du boîtier-support, les circuits intégrés étant répartis sur les deux grandes faces de ce boîtier, parcouru par un fluide de refroidissement.

De façon plus précise l'invention concerne une structure d'assemblage de circuits électroniques complexes, comportant une pluralité de circuits, intégrés ou hybrides, montés dans des boîtiers à connexions périmétriques ou surfaciques, un circuit d'interconnexion et un élément de refroidissement, caractérisée en ce que :

- le support de cette structure d'assemblage est constitué par l'élément de refroidissement, en forme de boîte comportant deux faces principales planes, parcouru par un fluide de refroidissement,

- le circuit d'interconnexion est posé sur au moins une face principale de l'élément de refroidissement,

- chaque boîtier de circuit électronique est électriquement relié au circuit d'interconnexion, sans soudure, par un cadre d'élastomère conducteur,

- chaque boîtier de circuit électronique est mécaniquement fixé sur le support de la structure par un cadre métallique, soumis à une pression qui maintient le cadre d'élastomère conducteur en compression entre le circuit d'interconnexion et les connexions du boîtier.

L'invention sera mieux comprise par la description d'un exemple de réalisation, laquelle s'appuie sur les figures jointes en annexe qui représentent :

- figure 1 : structure d'assemblage par cartes filles et carte mère selon l'art connu,

- figure 2 : vue éclatée d'une structure d'assemblage selon l'invention,

- figure 3 : vue en coupe d'une partie de la structure montrant le détail de fixation d'un boîtier,

- figure 4 : adaptation à la structure de différents types de boîtiers,

- figure 5 et 6 : vues en coupe de deux types d'élastomères conducteurs,

- figure 7 : vue de trois quart dans l'espace d'un boîtier comportant huit circuits intégrés en microboîtiers.

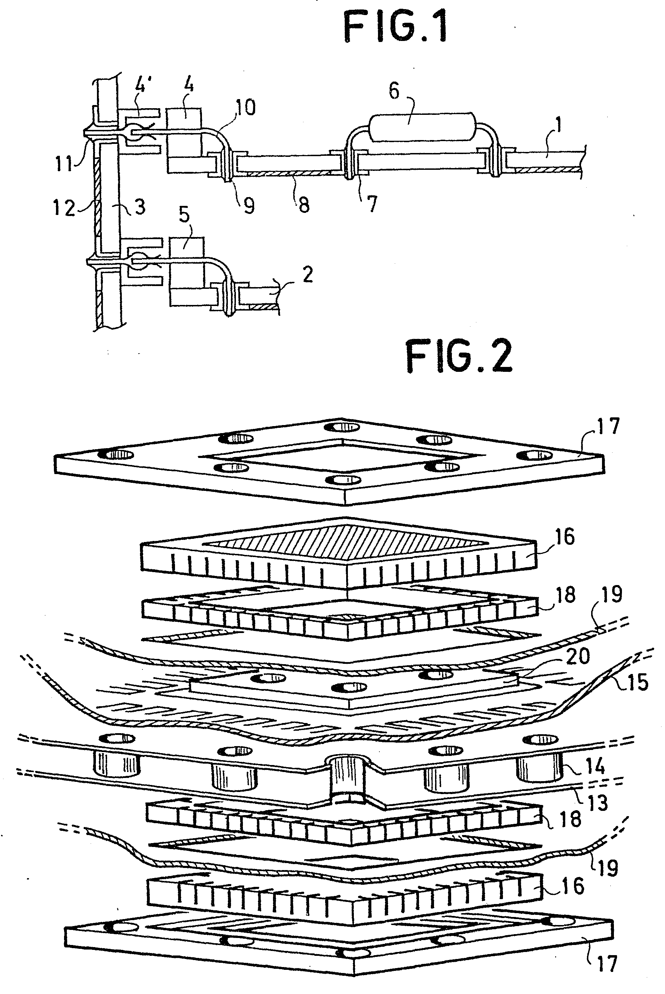

La figure 1 représente une structure d'assemblage par carte mère et cartes filles, selon l'art connu. Le procédé le plus couramment utilisé actuellement pour interconnecter un système complexe est de réaliser des sous-ensembles sur des cartes filles 1 et 2 qui sont interconnectées sur une carte mère 3 par l'intermédiaire de connecteurs 4 et 5. L'ensemble du système est disposé à l'intérieur d'un coffret qui assure à la fois le maintien des cartes de circuits imprimés et leur protection. Ce coffret est refroidi soit par convection naturelle soit par insuflation d'air à l'intérieur.

Si on considère la chaîne des interconnexions entre un composant 6, qui est par exemple un circuit intégré dans son microboîtier, supporté par la carte fille 1, jusqu'à un autre composant supporté par la carte -fille 2, on constate un nombre élevé d'interconnexions qui diminuent la fiabilité du système. Par exemple sur la figure 1, existe la chaîne des interconnexions suivantes :

- liaison entre la connexion externe du circuit intégré 6 et le trou métallisé 7 dans lequel cette connexion est soudée,

- liaison entre les métallisations des trous métallisés 7 et 9 et la piste conductrice 8 portée par la carte fille 1,

- liaison entre le trou métallisé 9 et la queue 10 du connecteur 4, soudée dans le trou 9,

- liaison entre la broche mâle du connecteur 4 et la tulipe femelle du connecteur 4', les deux moitiés assurant un connecteur à insertion,

- liaison entre la queue de la tulipe du connecteur 4' et le trou métallisé 11 dans lequel elle est soudée,

- liaison entre le trou métallisé 11 et la piste conductrice 12 portée par la carte mère 3,

- l'ensemble des liaisons précitées se répétant pour chaque carte fille, telle que la carte fille 2 qui comporte un autre circuit intégré avec lequel le circuit intégré 6 de la carte fille 1 doit être interconnecté.

L'ensemble de ces interconnexions, c'est-à-dire de contacts mécaniques comme ceux qui existent dans les connecteurs enfichables, de contacts entre des trous métallisés et des pistes conductrices, de contacts entre les connexions externes des composants et la soudure qui permet de les fixer sur les cartes filles constitue autant de sources virtuelles d'incidents par mauvais contact ou de rupture par suite de vibrations auxquelles le système peut être soumis.

De plus, les systèmes d'interconnexions par connecteurs enfichables sont sans doute recommandables pour pouvoir remplacer des cartes filles qui présentent un défaut, mais par contre les connecteurs en soi sont sources de défauts et il est préférable, pour obtenir une très grande fiabilité du matériel, de supprimer ces connecteurs. Par contre, le fait de réunir en une seule soudure telle que 7 les fonctions de fixation d'un composant et de liaison électrique présente d'autres inconvénients que ceux présentés par les connecteurs puisque, lorsqu'il s'agit de circuits intégrés ou de sous-ensembles relativement complexes encapsulés dans des boîtiers comportant jusque 40 connexions extérieures, le désoudage d'un boîtier fixé par 40 soudures pose un réel problème, surtout s'il s'agit de tester le composant ou de le remplacer : les soudures constituant une liaison électrique ne permettent pas d'isoler ce composant du reste du circuit pour le tester séparément.

Enfin, il est connu que l'augmentation de la densité d'intégration en microélectronique est accompagnée par une augmentation des dimensions des microboîtiers d'encapsulation. Que ces microboîtiers soient du type "chip carrier" ou du type circuit hybride, ils sont le plus généralement, surtout en électronique professionnelle, constitués d'un matériau céramique. Or, les céramiques ne sont pas flexibles, et les essais de vibration des cartes filles comportant des boîtiers céramiques fixés par soudures de leur connexion de sorties aboutissent fréquemment à des ruptures de soudures et même à l'éjection de composants, par suite des tensions induites par les soudures.

Enfin, en ce qui concerne le conditionnement et le refroidissement d'un système tel que représenté en figure 1 - et ces systèmes comportent généralement bien plus que deux cartes filles fixées sur une carte mère - les inconvénients des boîtiers sont essentiellement liés à leur volume et simultanément au fait que le refroidissement des composants s'opère mal, à moins d'injecter un courant d'air à l'intérieur du boîtier pour évacuer les calories dégagées au cours du fonctionnement. Dans ce cas, de toutes façons, les composants sont en contact direct avec le courant d'air, polluant qui dégrade les performances électriques.

La figure 2 représente un élément de la structure d'assemblage selon l'invention. Il a été dit précédemment que cette structure concerne essentiellement des systèmes complexes, donc qui comporte un assez grand nombre de sous-ensembles tels que des circuits intégrés encapsulés dans des boîtiers dits périmétriques ou surfaciques et dans ces conditions la représentation d'une structure complète serait illisible ; c'est pourquoi on a choisit de représenter la structure d'assemblage au niveau d'un composant, et comme cette structure est de façon préférée symétrique par rapport à son support central, la figure 2 comporte deux composants.

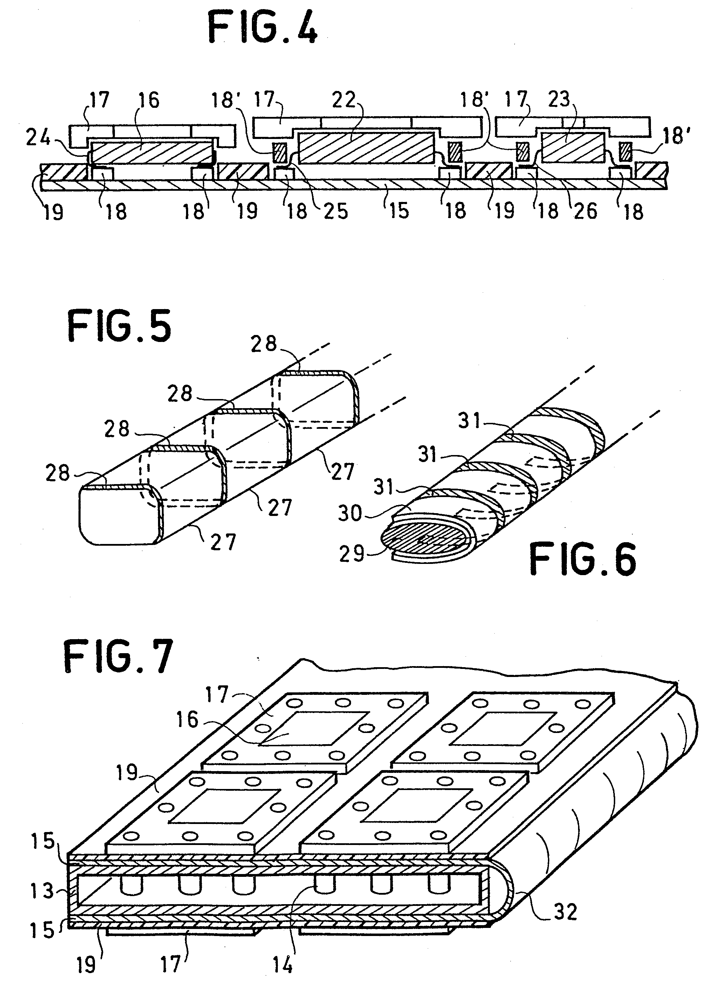

L'âme de la structure d'assemblage est constituée par un boîtier 13 en matériau bon conducteur, tel que le cuivre par exemple, ce boîtier ayant de préférence une forme de parallélipipède plat qui ressort mieux de la figure 7. Afin de simplifier les explications et ne pas donner lieu à des ambiguïtés avec les microboîtiers des composants, on conviendra d'appeler ce boîtier la boîte à vent, ce qui ne sous-entend nullement que des fluides tels que de l'eau ou de l'huile ne peuvent pas le parcourir.

La boîte à vent constitue l'élément de refroidissement de la structure. Elle peut être réalisée par assemblage, par brasure par exemple, de plaques en cuivre, ou en métal, maintenues par des entretoises 14. Mais elle peut également être réalisée en d'autres matériaux, tels que l'alumine qui est assez bonne conductrice thermique, ou en matières plastiques, par exemple en stratifié tissu de verre-époxy, ou en polyvinyl chlorure : si les matériaux choisis sont moins bons conducteurs thermiques, des inserts métalliques constituent des drains thermiques, aux endroits appropriés, sous les microboîtiers de circuits intégrés.

Sur une face principale de la boîte à vent 13 est déposé ou collé un circuit imprimé 15 : ce circuit comporte les pistes conductrices d'interconnexion entre les différents composants actifs 16 qui ne sont pas soudés sur les pistes de ce circuit d'interconnexion 15. La liaison entre un circuit intégré 16 et le circuit d'interconnexion 15 est assurée par la compression du boîtier de circuit intégré 16, par l'intermédiaire d'un cadre 17 qui vient appuyer le circuit intégré sur le circuit imprimé. Mais pour assurer un bon contact électrique, malgré les défauts de planéité possibles, malgré les vibrations possibles et les dilatations dues à la température au cours du fonctionnement, un élastomère conducteur 18 est intercalé entre la face inférieure du microboîtier de circuit intégré 16 et le circuit imprimé 15. La composition et la structure des différents types d'élastomères conducteurs utilisables seront détaillées ultérieurement.

Pour assurer un positionnement précis des connexions externes du circuit intégré 16 par rapport aux pistes du circuit imprimé 15, les dites connexions et les dites pistes étant de très faible largeur, de l'ordre de un demi milimètre, une plaque 19, réalisée en un matériau isolant, tel que par exemple une plaque tissu de verre imprégnée de résine époxy, permet de centrer parfaitement le circuit intégré 16 et l'élastomère conducteur 18 par rapport aux pistes du circuit imprimé 15. Cette plaque 19 est elle-même positionnée par les mêmes moyens que ceux qui positionnent le cadre métallique 17 par rapport au plan de référence générale de l'assemblage.

Enfin pour éviter le collage du circuit intégré 16 sur le circuit imprimé 15, ou sur le métal de la boîte à vent 13, selon la technique employée dans l'art connu pour assurer un contact thermique entre le fond de boîtier 16 et l'élément radiateur 13, la boîte à vent 13 comporte, à l'emplacement de chaque boîtier de circuit intégré, un bossage métallique 20 qui, passant à travers des trous convenablement réalisés dans le circuit imprimé 15, vient au contact du fond de boîtier 16. Ces bossages 20 sont eux-mêmes renforcés par des entretoises 21 qui rigidifient l'ensemble et servent de drains thermiques. Cette technique de bossage pour assurer un contact direct entre un élément de refroidissement et un boîtier d'encapsulation de circuit intégré a été révélée dans la demande de brevet français N° 82 01652 de la Demanderesse.

L'ensemble des pièces constituant un empilement pour la fixation et l'interconnexion du boîtier de circuit intégré 16 est fixé par l'intermédiaire de vis qui passent à travers le cadre 17 métallique et à travers la plaque 19 de tissu de verre. Ces vis sont enfoncées dans les entretoises 14, ce qui fait que, si le schéma s'y prête et que deux boîtiers de mêmes dimensions sont montés sur les deux faces opposées de la boîte à vent 13, l'effort de traction s'exerce de façon symétrique par deux vis vissées dans chaque entretroise 14, et il n'y donc pas de déformation de la structure mécanique d'ensemble.

Le vissage, à l'exclusion de toutes soudures des boîtiers de circuit intégré 16 permet donc, le cas échéant, de démonter un boîtier en dévissant son cadre, et par conséquent facilite le test et le remplacement d'un composant.

Le système de vissage peut être remplacé par un système d'étriers métalliques qui entoure chaque cadre 17, à la façon d'un clips : ces étriers sont encrés dans la boîte à vent 13 et ils fixent avec efficacité les circuits intégrés et les cadres 17 car ils sont choisis parmi des matériaux qui se dilatent à froid : dans une première phase à chaud, ils ont une structure cristalline austénitiques et dans une deuxième phase à froid, ils ont une structure cristalline martensitique qui présente environ 10 % d'allongement. Cet allongement est suffisant pour pouvoir faire pivoter les étriers sur le côté et dégager le cadre et le circuit intégré maintenus en place.

Le joint d'alastomère conducteur 18 a lui-même une épaisseur suffisante pour qu'il travaille en compression, écrasé contre le circuit imprimé 15 par le boîtier de circuit intégré 16 et le cadre 17.

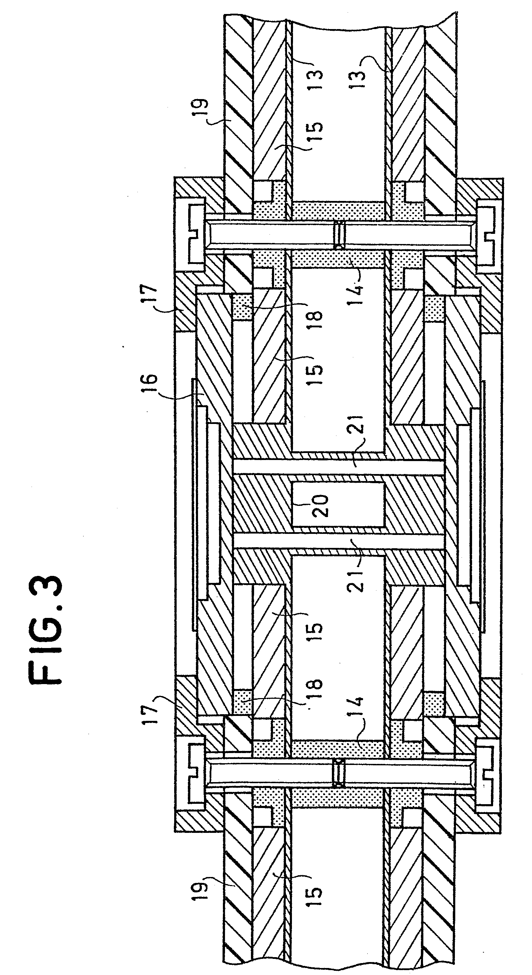

La figure 3 représente une vue en coupe d'une partie de la structure, montrant de façon plus précise que la figure 2 la fixation d'un boîtier et le drain thermique. Cette figure n'est que partielle par rapport à l'ensemble de la structure de l'invention puisqu'il a été précisé précédemment que cette structure comporte un grand nombre de boîtiers de circuits intégrés.

On retrouve sur la figure 3 la boîte à vent 13 sur les deux faces de laquelle sont placés l'empilement d'un circuit imprimé 15, un joint d'élastomère 18 et un boîtier du circuit intégré 16, ces deux derniers étant positionnés par le cadre isolant 19 et serrés par le cadre métallique 17. Cette figure, dont l'échelle des abscisses est dilatée de façon à favoriser la lecture du dessin, montre les entretoises 21 qui soutiennent le bossage 20, et servent de drains thermiques, puisqu'elles sont refroidies par le courant de fluide de refroidissement. Cette figure met également en évidence le fait qu'il n'y a aucune soudure pour l'interconnexion électrique et le maintien mécanique des boîtiers de circuit intégré : la fiabilité des contacts électriques est obtenue par l'élasticité présentée par l'élastomère conducteur 18 qui travaille en compression et résiste aux vibrations. Elle met enfin en évidence l'intérêt des entretoises 14 qui non seulement assurent une certaine rigidité à la boîte à vent 13 mais également servent au vissage des cadres 17 : les vis travaillant en opposition sur une même entretoise 14 ne déforment pas la boîte à vent 13.

La figure 4 montre l'adaptation possible de la structure selon l'invention à différents types de boîtiers. Trois modèles de microboîtiers d'encapsulation sont représentés sur cette figure :

- un microboîtier à connexions périmétriques replié sous le boîtier, dit "chip carrier" 16,

- un boîtier de circuit hybride 22,

- un boîtier de circuit intégré à connexions à plat 23, de type "Flat Pack".

11

Ces trois boîtiers sont montés sur un même circuit d'interconnexion 15 par l'intermédiaire de trois élastomères conducteurs 18. Le boîtier à connexions périmétriques 16 a des connexions de sortie latérales repliées sous le boîtier et ce cas a été exposé précédemment. Cependant, le boîtier "chip carrier" 16 peut également être à connexions surfaciques, c'est-à-dire que les connexions sont constituées par des plots qui sortent de la surface inférieure du boîtier, et qui prennent contact directement avec le cadre de l'élastomère conducteur.

Le boîtier de circuit hybride 22 est doté de connexions externes 25 qui, selon le fondement même de l'invention qui est d'assurer une prise de contact par écrasement et non pas par soudure, sont de types repliées à plats, en tout point comparables au boîtier plat dits "Flat Pack" représenté en 23, dont les connexions de sortie 26 ne sont pas enfichables comme dans un boîtier DIL mais sont à plat. Dans le cas des boîtiers de circuits hybrides 22 ou du boîtier "Flat Pack" 23, l'invention prévoit que le cadre 17 qui tient en place le boîtier est prévu pour que les vis de fixation dans la boîte à vent 13 passent à l'extérieur du périmètre des connexions 25 et 26.

Cependant, les connexions à plat ont, compte-tenu de leurs très petites dimensions, une souplesse qui ne permettrait pas d'écraser l'élastomère conducteur 18. C'est pourquoi, dans ce cas, il est préférable de communiquer plus de rigidité aux connexions à plat en les soumetant à une pression, à partir du cadre métallique 17, par l'intermédiaire d'une pièce isolante 18', soit rigide, soit élastomère. Les connexions sont alors serrées entre deux pièces élastomères 18 et 18', dont les forces de compression s'équilibrent.

Les figures 5 et 6 donnent deux vues en coupe de deux types d'élastomères conducteurs. Seule une fraction linéaire de ces élastomères conducteurs est représentée, alors que, selon l'invention l'élastomère conducteur 18 qui assure le contact sans soudure entre le circuit intégré 16 et le circuit imprimé 15 a la forme d'un carré ou d'un rectangle, selon le type de microboîtier.

En figure 5, l'élastomère conducteur représenté est constitué par un cordon découpé dans un sandwich constitué par l'empilement de feuilles d'élastomère 27 et de feuilles métalliques 28. Les feuilles métalliques 28 ont une épaisseur suffisante pour qu'un contact puisse être pris par la tranche, d'une part sur la piste conductrice d'un circuit imprimé 15, d'autre part sur la connexion extérieure d'un boîtier de circuit intégré 16. Dans l'empilement de couches d'élastomère et de couches métalliques réalisé sont découpés, perpendiculairement aux couches, des cordons qui sont ensuite mis en forme pour constituer le cadre dit "d'élastomère conducteur" 18 nécessaire pour un boîtier donné.

La figure 6 représente une variante à la structure d'un élastomère conducteur. Selon cette variante le cordon d'élastomère dit conducteur est constitué par une âme 29 en élastomère sur laquelle est plaquée sur au moins trois faces une feuille souple 30 qui porte des pistes métalliques conductrices 31. Dans les deux cas de configuration d'élastomère conducteur, les pistes conductrices qui sont constituées soit par la tranche des feuilles 28 soit par les pistes 31, sont bien entendu à un écartement qui correspond à l'écartement normalisé des microboîtiers d'encapsulation de circuits intégrés.

Une variante de réalisation d'élastomère conducteur est un élastomère isolant dont certaines parties destinées aux connexions sont rendues conductrices par inclusion d'éléments conducteurs. Les dits éléments sont par exemple le carbone ou l'argent.

La figure 7 représente une vue de trois quart dans l'espace d'une structure d'assemblage selon l'invention. Cette vue est ouverte à une extrémité pour montrer sa structure intérieure, et n'est pas limitée à son autre extrémité : aux quatre boîtiers de circuits intégrés représentés sur la face visible correspondent également quatre boîtiers de circuits intégrés cachés, sous la boîte à vent 13. Cependant, il est bien évident qu'une face seulement de la structure peut être utilisée bien que cette solution soit moins intéressante.

L'intérêt de la figure 7 est de montrer que l'interconnexion entre les microboîtiers portés par une face de la structure et les microboîtiers portés par l'autre face de la structure peut se réaliser directement par l'intermédiaire d'un unique circuit imprimé de liaison 32 souple qui est replié autour de la boîte à vent. Ce cas est particulièrement intéressant puisqu'il supprime les connecteurs entre deux circuits d'interconnexion 15. Deux solutions sont possibles. Soit les deux circuits 15 et le circuit de liaison 32 entre eux sont réalisés en un seul circuit souple. Soit les circuits 15 sont rigides et multicouches, et incluent une couche souple 32 : ces circuits imprimés sont connus sous l'appellation flex-rigide.

En outre, cette figure met en évidence le fait que la plaque de centrage 19, qui positionne les boîtiers de circuits intégrés 16 et les cadres d'élastomère conducteur 18, constitue une protection externe du circuit imprimé 15. Cette protection est complétée par les cadres métalliques 17, à l'intérieur desquels apparaissent les couvercles métalliques de fermeture des microboîtiers 16. Ainsi l'ensemble de la structure constitue en soi un coffret intégré puisqu'il n'est plus utile de monter l'ensemble dans un coffret de protection.

La structure selon l'invention réalise donc un coffret intégré, qui est utilisable directement, refroidi par l'intérieur par un fluide de refroidissement, et réalisé selon une structure telle qu'il n'y a pas de soudure d'interconnexion entre les microboîtiers et le circuit imprimé, ce qui favorise l'interchangeabilité des microboîtiers 16, leurs tests, leurs remplacements, et améliore considérablement la fiabilité face aux variations de température et aux vibrations.

Le coffret intégré représenté en figure 7 est bien entendu complété à ses deux extrémités par des moyens pour introduire un fluide de refroidissement, et par des moyens de connexions du circuit imprimé 15 avec le reste du système électronique dans la réalisation duquel entre ce coffret intégré.

La conception de ce coffret intégré découle également d'un procédé de montage de circuits intégrés, ce procédé étant orienté vers une meilleure fiabilité face aux vibrations et une meilleure adaptation à l'entretien et à la réparation.

D'autres effets techniques et avantages de l'invention sont :

- un encombrement plus faible,

- la minimisation des interconnexions,

- la suppression des connecteurs entre cartes mères et cartes filles,

- la séparation des fonctions de maintien et d'interconnexion des éléments,

- un refroidissement efficace, éventuellement par liquide, et non polluant,

- une compatibilité avec tous les microboîtiers d'encapsulation.

L'invention est précisée par les revendications suivantes.

REVENDICATIONS

1. Structure d'assemblage de circuits électroniques complexes, comportant une pluralité de circuits, intégrés, ou hybrides montés, dans des boîtiers (16) à connexions périmétriques ou surfaciques, un circuit d'interconnexion (15) et un élément de refroidissement (13), caractérisée en ce que :

- le support de cette structure d'assemblage est constitué par l'élément de refroidissement (13), en forme de boîte comportant deux faces principales planes, parcouru par un fluide de refroidissement,

- le circuit d'interconnexion (15), est posé au moins sur une face principale de l'élément de refroidissement (13),

- chaque boîtier de circuit électronique (16) est électriquement relié au circuit d'interconnexion (15), sans soudure, par un cadre d'élastomère conducteur (18),

- chaque boîtier de circuit électronique (16) est mécaniquement fixé sur le support (13) de la structure par un cadre métallique (17), soumis à une pression qui maintient le cadre d'élastomère conducteur (18) en compression entre le circuit d'interconnexion (15) et les connexions du boîtier (16).

2. Structure d'assemblage selon la revendication 1, caractérisée en ce que les cadres d'élastomère conducteur (18) sont positionnés par rapport aux pistes conductrices du circuit d'interconnexion (15) par une plaque (19), en matériau isolant, percée d'orifices dont les dimensions et la position correspondent aux pistes conductrices du circuit d'interconnexion (15) avec lesquelles les cadres d'élastomère conducteur (18) sont en contact.

3. Structure d'assemblage selon la revendication 1, caractérisée en ce que les boîtiers (16) de circuits électroniques sont positionnés par rapport aux cadres d'élastomère conducteur (18) par les cadres métalliques (17).

4. Structure d'assemblage selon la revendication 1, caractérisée en ce que, en vue de supprimer les connecteurs mécaniques, un circuit de liaison (32), sur support souple, réunit deux circuits d'interconnexion (15), appliqués sur deux faces principales de l'élément de refroidissement (13).

5. Structure d'assemblage selon l'une quelconque des revendications 1 à 4, caractérisée en ce qu'elle constitue en elle-même un coffret intégré et auto-protégé, dans lequel les circuits électroniques (16) et d'interconnexion (15) sont supportés par l'élément de refroidissement (13), central, et protégés extérieurement par les plaques isolantes (19) de positionnement et par les cadres métalliques (17).

6. Procédé d'assemblage de circuits électroniques complexes caractérisé en ce que, en vue de :

- diminuer l'encombrement total,
- améliorer le refroidissement,
- diminuer le nombre d'interconnexions,

l'élément de refroidissement (13), comportant au moins deux faces principales planes, constitue le support contre lequel est appliqué au moins un circuit d'interconnexion (15).

7. Procédé d'assemblage de circuits électroniques complexes caractérisé en ce que, en vue de :

- faciliter les opérations de test et de maintenance,
- améliorer la fiabilité en température et en vibrations,

les fonctions de liaisons électriques et de fixation mécanique des boîtiers de circuits électroniques (16) sont dissociées, les liaisons électriques entre boîtiers (16) et circuit d'interconnexion (15) étant assurées par élastomères conducteurs (18), sous pression, et la fixation mécanique des boîtiers (16) et des élastomères conducteurs (18) étant assurée par des cadres métalliques (17), vissés dans l'élément de refroidissement (13), et par une plaque isolante (19) de positionnement latéral.

0116802

1/3

FIG.1

FIG.2

FIG.3

## FIG.4

## FIG.5

## FIG.6

## FIG.7

**0116802**
Numéro de la demande

Office européen
des brevets

**RAPPORT DE RECHERCHE EUROPEENNE**

EP  83 40 2542

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y | FR-A-2 331 891  (TEKTRONIX INC.)<br><br>* Page 4, ligne 8 - page 6, ligne 31; figures 1,3 * | 1-3,5-7 | H 05 K    7/20<br>H 01 R   23/72<br>H 01 L   23/32<br>H 01 L   23/46 |
| Y | DESIGN ENGINEERING, août 1980, page 21, Londres, GB<br>"Two elastomer-based connection systems for electronic packaging"<br>* Page 21, colonne 2 * | 1-3,5-7 | |
| A | ELEKTRONIK, no. 23, novembre 1981, pages 55-58, Munich, DE<br>H. DANIELSSON: "Hohe Zuverlässigkeit durch Chip-Carier-Technik" * Page 57, paragraph 6; figure 5 * | 1,4 | |
| A | US-A-4 169 642  (E.I. DU PONT DE NEMOURS) | | |
| A | DE-A-2 345 626  (SIEMENS AG) | | |

**DOMAINES TECHNIQUES RECHERCHES (Int. Cl. ³)**

H 05 K
H 01 R
H 01 L

Le présent rapport de recherche a été établi pour toutes les revendications

| Lieu de la recherche | Date d'achèvement de la recherche | Examinateur |
|---|---|---|
| LA HAYE | 26-04-1984 | SCHUERMANS N.F.G. |